# EUROPEAN PATENT APPLICATION

(11) **EP 4 823 312 A2**
(43) Date of publication of application: **14.10.2026**
(21) Application number: 26166240.7
(22) Date of filing: 19.03.2026
(51) Int. Cl.: H10W 90/10, H10W 40/25, H10W 72/50, H10W 74/10, H10W 90/00

(54) **POWER MODULE, POWERTRAIN, AND ELECTRIC VEHICLE**

(30) Priority: 21.03.2025 CN 202510346988
(71) Applicant: HUAWEI TECHNOLOGIES CO., LTD., Shenzhen 518129 (CN)
(72) Inventor: YUAN, Bo, Shenzhen, 518129 (CN); LV, Zhen, Shenzhen, 518129 (CN); SHI, Yidian, Shenzhen, 518129 (CN); LIU, Yumin, Shenzhen, 518129 (CN); LV, Yafei, Shenzhen, 518129 (CN)
(74) Representative: Gill Jennings & Every LLP

(57) **Abstract**

This application relates to the field of power electronics technologies, and in particular, to a power module, a powertrain, and an electric vehicle. The power module includes a substrate, an input, an output, a first switch component group, and a second switch component group. The substrate includes a first metal layer, a second metal layer, and a third metal layer that are isolated from each other. The first switch component group and the second switch component group are arranged in a first direction, and the third metal layer is arranged between the first switch component group and the second switch component group in the first direction. The first switch component group includes a plurality of first switch components, the second switch component group includes a plurality of second switch components, each first switch component is disposed on the first metal layer and is connected to the second metal layer, and each second switch component is disposed on the second metal layer and is connected to the third metal layer. A first input terminal is disposed on the first metal layer, a second input terminal is disposed on the third metal layer, and the output is disposed on the second metal layer. The power module can achieve both low parasitic inductance and a miniaturized design.

## Description

### TECHNICAL FIELD

This application relates to the field of power electronics technologies, and in particular, to a power module, a powertrain, and an electric vehicle.

### BACKGROUND

A power module is a core component in a power electronic device, and implements conversion and management of electric energy by integrating one or more power semiconductor components. Therefore, power modules are widely used in fields such as a photovoltaic field, an energy storage field, and an electric vehicle field.

Presence of parasitic inductance may lead to a series of problems such as circuit oscillation. In this case, low parasitic inductance becomes one of key objectives during power module design. In addition, a structure design of the power module further needs to meet a product requirement for miniaturization.

### SUMMARY

This application provides a power module, a powertrain, and an electric vehicle. The power module can achieve both low parasitic inductance and a miniaturized design.

According to a first aspect, this application provides a power module. The power module includes a substrate, an input, an output, a first switch component group, and a second switch component group. The substrate includes a plurality of metal layers that are isolated from each other, and the plurality of metal layers include a first metal layer, a second metal layer, and a third metal layer. The first switch component group and the second switch component group are arranged in a first direction, and the third metal layer is arranged between the first switch component group and the second switch component group in the first direction. The first switch component group includes a plurality of first switch components disposed on the first metal layer, and the second switch component group includes a plurality of second switch components disposed on the second metal layer. Each first switch component is disposed on the first metal layer and is connected to the second metal layer, and each second switch component is disposed on the second metal layer and is connected to the third metal layer. The input and the output are disposed on two sides of the substrate in a second direction, and a thickness direction of the substrate, the first direction, and the second direction are perpendicular to each other. The input includes a first input terminal and a second input terminal that are spaced apart in the first direction, the first input terminal is configured to connect to the first metal layer, the second input terminal is configured to connect to the third metal layer, and the first input terminal and the second input terminal are respectively configured to connect to a positive electrode and a negative electrode of a power supply. The output is configured to connect to the second metal layer, and the output is configured to output an alternating current.

According to the power module provided in this embodiment of this application, the first switch component group configured to form an upper bridge arm and the second switch component group configured to form a lower bridge arm are spaced apart in the first direction. A loop that is in a bridge arm circuit formed by the power module and that is configured to connect to the power supply has a current path in a reverse direction, so that parasitic inductance in the current loop can be reduced, and impact of the parasitic inductance on a function of the power module can be reduced. The third metal layer configured to connect to the second input terminal is arranged between the first switch component group and the second switch component group, so that circuit wiring of each first switch component and each second switch component can use a gap between the first switch component group and the second switch component group, to help reduce a size of the power module in the first direction. For a structure design of the entire power module, parasitic inductance in a circuit can be reduced while achieving miniaturization of a component. This helps optimize the function of the power module.

In an embodiment, at least a part of the second switch components are arranged in the second direction, and an end portion that is of the second input terminal and that faces the output extends in the second direction to be between the first switch component group and the second switch component group to connect to the third metal layer. An orthographic projection of the second input terminal on the substrate at least partially overlaps the third metal layer in the thickness direction of the substrate. The second input terminal can extend to between the first switch component group and the second switch component group, so that the second switch component performs circuit wiring to the second input terminal through the third metal layer.

In an embodiment, the second input terminal includes a body and at least one elastomer configured to connect to the third metal layer. One end or two ends of each elastomer are connected to the body, and each elastomer protrudes, in the thickness direction of the substrate, from a surface that is of the body and that faces the third metal layer. The second input terminal is connected to the third metal layer through the elastomer, so that connection reliability can be enhanced while meeting a good electrical connection requirement.

In an embodiment, the elastomer is connected to the body in the second direction, the elastomer extends relative to the body in the second direction to connect to the third metal layer, and current paths of currents to the second input terminal through the elastomer are different. In a structure design of the power module, structures of second switch components at different positions and the elastomer are designed in combination, so that a difference between current paths of different second switch components can be reduced, and a current sharing effect can be improved.

In an embodiment, the second input terminal includes at least one pair of parallel strip grooves, each pair of strip grooves are arranged in the first direction, and a part that is of the second input terminal and that is located between each pair of strip grooves forms one elastomer. Distances of the current path from the third metal layer to two ends of the elastomer and the second input terminal in the second direction are different, so that lengths of paths from the second switch components at different positions to the input can be changed.

In an embodiment, the second input terminal includes at least one U-shaped groove, an opening of the U-shaped groove in the second direction faces the output or the input, and a part that is of the second input terminal and that is located in the U-shaped groove forms one elastomer. Distances of the current path from the third metal layer to the elastomer and the second input terminal in the second direction may be changed based on a groove opening design of the U-shaped groove, so that lengths of paths from the second switch components at different positions to the input can be changed.

In an embodiment, the second metal layer and the third metal layer are disposed on a same layer, the second metal layer includes a notch, the third metal layer is accommodated in the notch, and there is a gap between the second metal layer and the third metal layer. The second metal layer and the third metal layer may be disposed on the same layer in a manner such as etching, to simplify a preparation process.

In an embodiment, the notch includes at least one hollow structure that penetrates the second metal layer, and a position at which each first switch component is connected to the second metal layer is located between the third metal layer and the first metal layer in the first direction. Circuit connections between the plurality of first switch components and the plurality of second switch components may share space between the first switch component group and the second switch component group, thereby helping reduce the size of the power module in the first direction.

In an embodiment, the notch includes at least one groove that is of the second metal layer and that faces an edge of the first metal layer. A position at which one first switch component is connected to the second metal layer and a position at which one second switch component is connected to the third metal layer are spaced apart in the second direction. Circuit connections between the plurality of first switch components and the plurality of second switch components may share space between the first switch component group and the second switch component group, thereby helping reduce the size of the power module in the first direction.

In an embodiment, the third metal layer includes a plurality of third metal islands, and each third metal island is connected to the second input terminal. The plurality of third metal islands are spaced apart in the second direction, and each second switch component is connected to one third metal island. The second connection terminal and the plurality of third metal islands implement multi-point connection, and the current paths of the second switch components at different positions connected to the input may be changed based on position designs of different third metal islands. This helps improve the current sharing effect of the circuit.

In an embodiment, the first input terminal includes two terminal ends, and the second input terminal is arranged between the two terminal ends in the first direction. In the thickness direction of the substrate, an orthographic projection of the second input terminal on the third metal layer overlaps the first metal layer, and the second input terminal avoids the first metal layer. The design of the first input terminal with two terminal ends may further reduce the parasitic inductance in the current loop.

In an embodiment, the first metal layer and the third metal layer are disposed on a same layer. In the thickness direction of the substrate, there is a gap between the second input terminal and the first metal layer, and a surface that is of the second input terminal and that faces the third metal layer is connected to the third metal layer through a pad. The second input terminal can avoid a metal layer other than the third metal layer.

In an embodiment, the first metal layer includes two isolated first metal islands, and the two first metal islands are arranged on two sides of the second input terminal in the first direction. The two first metal islands are connected through a connection bridge, and the connection bridge crosses the second input terminal in the first direction. The second input terminal can avoid a metal layer other than the third metal layer.

In an embodiment, in the first direction, the plurality of first switch components included in the first switch component group and the plurality of second switch components included in the second switch component group are distributed axisymmetrically about the third metal layer, so that the parasitic inductance generated in the current loop can be further reduced.

According to a second aspect, this application provides a powertrain. The powertrain includes a controller and a motor, and the controller includes a plurality of power modules provided in the first aspect. The first input terminal and the second input terminal of each power module are respectively configured to connect to a positive electrode and a negative electrode of a power supply, and the output terminal of each power module is configured to connect to a one-phase circuit of the motor. The foregoing power module can achieve both a small size and low parasitic inductance. This helps improve efficiency of the powertrain and reduce a size of the powertrain.

According to a third aspect, this application provides an electric vehicle. The electric vehicle includes a power battery, a wheel, and the powertrain according to the second aspect, a power conversion apparatus of the powertrain is configured to: receive a direct current from the power battery, convert the direct current into an alternating current, and output the alternating current to the motor, and the motor is in transmission connection to the wheel. The electric vehicle including the foregoing powertrain has better power performance.

For technical effects that can be achieved in the second aspect and the third aspect, refer to corresponding effect descriptions in the first aspect. Details are not described herein again.

### BRIEF DESCRIPTION OF DRAWINGS

FIG. 1a is a diagram of a structure of an electric vehicle according to an embodiment of this application;
FIG. 1b is a diagram of an operating principle of a powertrain of an electric vehicle according to an embodiment of this application;
FIG. 2 is a schematic of a power conversion circuit of a powertrain according to an embodiment of this application;
FIG. 3 is a diagram of a structure of a power module according to an embodiment of this application;
FIG. 4a is a diagram of a structure of a power module according to an embodiment of this application;
FIG. 4b is a diagram of a structure of a power module according to an embodiment of this application;
FIG. 5a is a diagram of a structure of a power module according to an embodiment of this application;
FIG. 5b is a diagram of a partial structure of a power module according to an embodiment of this application;
FIG. 6a is a diagram of a structure of a power module according to an embodiment of this application;
FIG. 6b is a diagram of a cross-sectional structure of a power module according to an embodiment of this application;
FIG. 6c is a diagram of a cross-sectional structure of a power module according to an embodiment of this application;
FIG. 7a is a diagram of a current loop of a power module according to an embodiment of this application;
FIG. 7b is a diagram of a partial current loop of a power module according to an embodiment of this application;
FIG. 8a is a diagram of a current loop of a power module according to an embodiment of this application;
FIG. 8b is a diagram of a partial current loop of a power module according to an embodiment of this application;
FIG. 9a is a diagram of a structure of a power module according to an embodiment of this application;
FIG. 9b is a diagram of a cross-sectional structure of a power module according to an embodiment of this application;
FIG. 9c is a diagram of a cross-sectional structure of a power module according to an embodiment of this application;
FIG. 10a is a diagram of a current loop of a power module according to an embodiment of this application;
FIG. 10b is a diagram of a partial current loop of a power module according to an embodiment of this application;
FIG. 11 is a diagram of a structure of a power module according to an embodiment of this application;
FIG. 12a is a diagram of a partial structure of a second input terminal of a power module according to an embodiment of this application;
FIG. 12b is a cross-sectional view of a partial structure of a second input terminal of a power module according to an embodiment of this application;
FIG. 13a is a diagram of a partial structure of a second input terminal of a power module according to an embodiment of this application;
FIG. 13b is a cross-sectional view of a partial structure of a second input terminal of a power module according to an embodiment of this application;
FIG. 14 is a diagram of a partial current loop of a power module according to an embodiment of this application;
FIG. 15a is a diagram of a structure of a power module according to an embodiment of this application;
FIG. 15b is a diagram of a cross-sectional structure of a power module according to an embodiment of this application;
FIG. 15c is a diagram of a cross-sectional structure of a power module according to an embodiment of this application;
FIG. 16 is a diagram of a current loop of a power module according to an embodiment of this application;
FIG. 17 is a diagram of a partial structure of a power module according to an embodiment of this application;
FIG. 18a is a diagram of a structure of a power module according to an embodiment of this application;
FIG. 18b is a diagram of a cross-sectional structure of a power module according to an embodiment of this application;
FIG. 18c is a diagram of a cross-sectional structure of a power module according to an embodiment of this application;
FIG. 19a is a diagram of a structure of a power module according to an embodiment of this application;
FIG. 19b is a diagram of a structure of a power module according to an embodiment of this application;
FIG. 19c is a diagram of a structure of a power module according to an embodiment of this application;
FIG. 20 is a diagram of a partial structure of a power module according to an embodiment of this application;
FIG. 21 is a diagram of a structure of a power module according to an embodiment of this application;
FIG. 22a is a diagram of a structure of a power module according to an embodiment of this application;
FIG. 22b is a diagram of a cross-sectional structure of a power module according to an embodiment of this application;
FIG. 23a is a diagram of a structure of a power module according to an embodiment of this application;
FIG. 23b is a diagram of a structure of a power module according to an embodiment of this application;
FIG. 23c is a diagram of a structure of a power module according to an embodiment of this application;
FIG. 24a is a diagram of a structure of a power module according to an embodiment of this application; and
FIG. 24b is a diagram of a structure of a power module according to an embodiment of this application.

### Reference numerals:

1000: powertrain; 2000: vehicle body; 3000: wheel; 4000: power battery;
100: motor control unit; 200: motor;
10: power conversion circuit; 20: drive circuit; 30: controller;
1: substrate; 11: bottom plate; 12: metal layer; 121: first metal layer; 1211: first metal island; 1212: connection bridge; 122: second metal layer; 123: third metal layer; 1231: third metal island; 13: insulation layer; 2: input; 21: first input terminal; 211: terminal end; 22: second input terminal; 3: output; 4: power switch component; 41: first switch component; 42, 42a, 42b, and 42c: second switch components; 5: package body; 6: adapter member;
A1: first direction; A2: second direction; G1: first switch component group; G2: second switch component group; K: hollow structure; P: pad; W: groove; t1 and t2: elastomer.

### DESCRIPTION OF EMBODIMENTS

A power electronic converter system including a power module may perform energy conversion through a power conversion circuit. Parasitic inductance in the power conversion circuit is likely to cause circuit oscillation. An existing power module design for reducing parasitic inductance is difficult to meet a requirement for miniaturization of a power module in a specific application scenario.

Based on this, embodiments of this application provide a power module, a powertrain, and an electric vehicle. The power module can reduce parasitic inductance in a circuit while meeting a design requirement for module miniaturization.

To make the objectives, technical solutions, and advantages of this application clearer, the following further describes this application in detail with reference to accompanying drawings.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification means that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", "have", and variants thereof all mean "include but are not limited to", unless otherwise specifically emphasized in another manner.

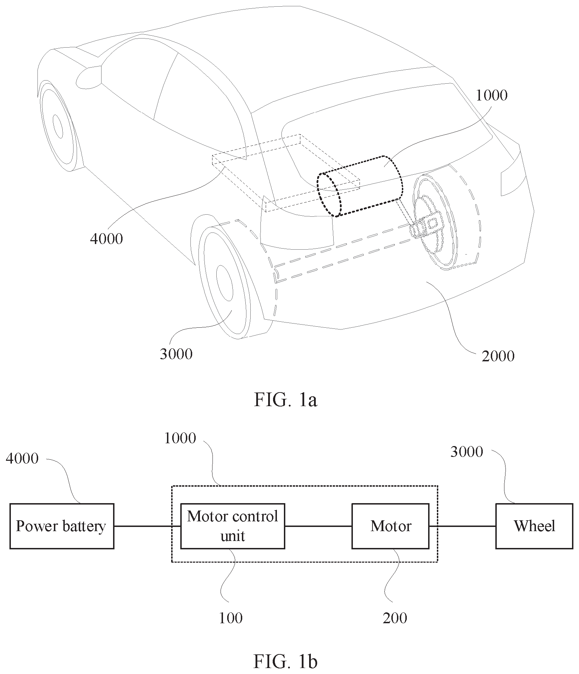

FIG. 1a shows an example of a structure of an electric vehicle according to an embodiment of this application. In this embodiment of this application, the electric vehicle is a wheeled device driven or towed by a power apparatus. In an implementation, the electric vehicle includes a passenger vehicle, a commercial vehicle, or a specialized operation vehicle such as an engineering emergency rescue vehicle, a sprinkler, a vacuum truck, a concrete mixer trucker, a crane, or a medical vehicle. For example, the electric vehicle includes an electric vehicle (EV), a pure electric vehicle/battery electric vehicle (PEV/BEV), a hybrid electric vehicle (HEV), a range extended electric vehicle (REEV), a plug-in hybrid electric vehicle (PHEV), or the like.

As shown in FIG. 1a, the electric vehicle includes a power battery 4000, a wheel 3000, a vehicle body 2000, and a powertrain 1000. The powertrain 1000, the power battery 4000, and the wheel 3000 are assembled on the vehicle body 2000.

As shown in FIG. 1b, the powertrain 1000 includes a motor control unit 100 and a motor 200. The motor control unit 100 is configured to receive a direct current from the power battery 4000, and is configured to output an alternating current to the motor 200. The motor 200 is configured to receive the alternating current that is output by the motor control unit 100, and is configured to drive the wheel 3000 of the electric vehicle. In an embodiment, the powertrain 1000 integrates the motor 200 and the motor control unit 100 into a housing, so that integration of the powertrain 1000 can be increased, and a size and costs can be reduced. This helps achieve a lightweight design of the powertrain 1000 and improve power density.

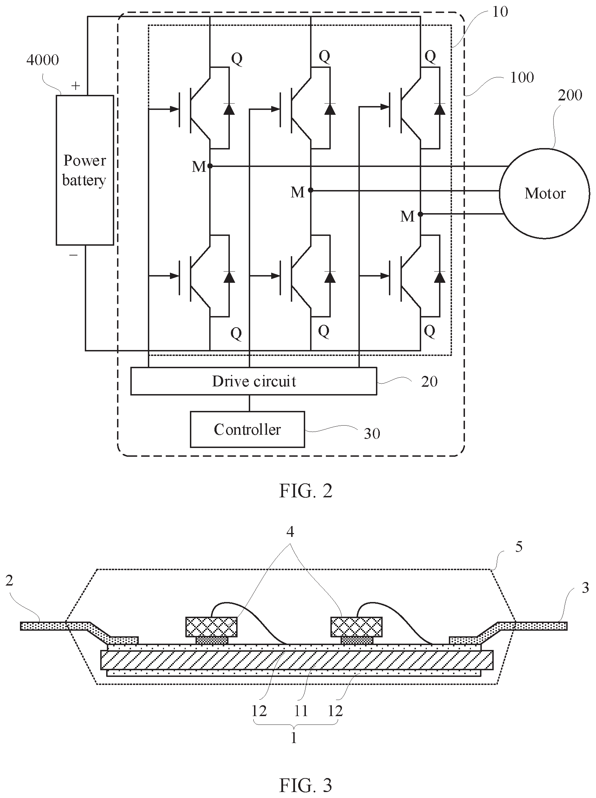

In this embodiment of this application, the motor control unit 100 includes a power conversion circuit 10, a drive circuit 20, and a controller 30 that are shown in FIG. 2. The power conversion circuit 10 includes a three-phase bridge arm circuit. Two ends of a bridge arm of each phase of the bridge arm circuit are configured to receive power supplied by the power battery 4000, and a bridge arm midpoint M of each phase of the bridge arm circuit is configured to output a one-phase alternating current to the motor 200 to drive the motor 200. The power battery 4000 is a power supply of the electric vehicle.

As shown in FIG. 2, a group of power switch components Q is connected in series between an end that is of each phase bridge arm and that is configured to connect to a positive electrode of the power battery 4000 and the bridge arm midpoint M, to form an upper bridge arm of the bridge arm circuit, and the group of power switch components Q is configured to control an upper bridge arm circuit to be connected or disconnected. A group of power switch components Q is connected in series between an end that is of each phase bridge arm and that is configured to connect to a negative electrode of the power battery 4000 and the bridge arm midpoint M, to form a lower bridge arm of the bridge arm circuit, and the group of power switch components Q is configured to control a lower bridge arm circuit to be connected or disconnected. The drive circuit 20 may output a drive signal to each of the power switch components Q based on a control signal sent by the controller 30 to control each of the power switch components Q to be turned on or turned off, to output a three-phase alternating current to a three-phase winding of the motor 200, so that the motor 200 outputs a required torque to drive the electric vehicle to travel.

In an embodiment, the motor control unit 100 includes a plurality of power modules, and the plurality of power modules are configured to form the power conversion circuit shown in FIG. 2. Each power module is a combination of power electronic components that can implement a power conversion function. The power electronic component includes an insulated gate bipolar transistor (IGBT), a silicon carbide power transistor, a silicon transistor, a metal-oxide-semiconductor field-effect transistor (MOSFET), a diode, and the like. The power electronic devices included in each power module can be electrically connected to form a one-phase bridge arm circuit shown in FIG. 2.

As shown in FIG. 3, the power module provided in this embodiment of this application includes a substrate 1, an input 2, an output 3, and a power switch component 4. The power switch component 4 herein is the foregoing power electronic component. The substrate 1 includes a bottom plate 11 and a conductive layer 12 disposed on the bottom plate 11. The conductive layer 12 and the plurality of power switch components 4 form a bridge arm circuit shown in FIG. 2. The bridge arm circuit is connected to a positive electrode and a negative electrode of the power supply through the input 2, and the bridge arm circuit outputs an alternating current through the output 3.

In some embodiments, the substrate 1 is a direct bonded copper board. A double-sided copper clad laminate (DCL) is used as an example. The bottom plate 11 may be made of an insulating material, for example, ceramic or glass, one conductive layer 12 is disposed on each of two sides of the bottom plate 11 in a thickness direction, and the conductive layer 12 is specifically a copper layer. The conductive layer 12 may alternatively be an aluminum layer or another conductive metal layer. The power switch component 4 of the power module is connected to one of the conductive layers 12 to form a bridge arm circuit, and the input 2 and the output 3 are connected to the conductive layer 12. The other conductive layer 12 does not participate in electrical connection of the bridge arm circuit, and therefore is omitted in the following embodiments.

In an embodiment, the power module further includes a package body 5. The package body 5 wraps and packages the substrate 1 and the plurality of power switch components 4, and ends that are of the input 2 and the output 3 and that are away from the substrate 1 are separately exposed outside the package body 5, to help connect to an electrical component.

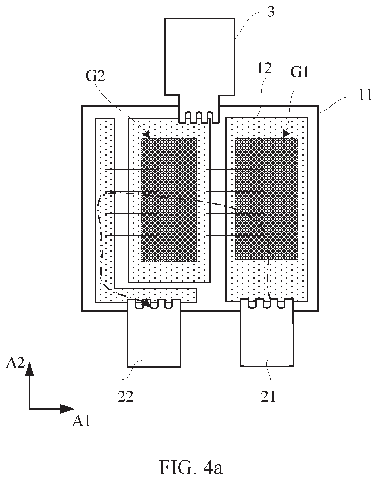

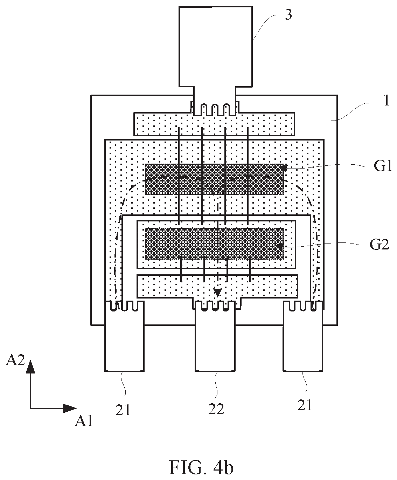

FIG. 4a and FIG. 4b show examples of structural layouts of two power modules. For example, a substrate 1 is rectangular. For ease of understanding, based on a shape of the substrate 1, a first direction A1 and a second direction A2 are defined as being perpendicular to a thickness direction of the substrate 1, and the first direction A1 is perpendicular to the second direction A2. An input 2 and an output 3 of the power module are opposite to each other in the second direction A2. The input 2 includes a first input terminal 21 and a second input terminal 22 that are spaced apart in the first direction A1, and the first input terminal 21 and the second input terminal 22 are respectively configured to connect to a positive electrode and a negative electrode of a power supply. A power switch component 4 includes a first switch component group G1 and a second switch component group G2. The first switch component group G1 is connected to a conductive layer 12 to form an upper bridge arm, and the second switch component group G2 is connected to the conductive layer 12 to form a lower bridge arm. A dashed line with an arrow indicates a loop that is in a bridge arm circuit and that is configured to connect to the power supply.

The power module shown in FIG. 4a is of a 2DC architecture design, and the input 2 includes one first input terminal 21 and one second input terminal 22. The first switch component group G1 and the second switch component group G2 are arranged in the first direction A1, both the first switch component group G1 and the second switch component group G2 are routed and arranged leftward in the first direction A1, and the power module has a large size in the first direction A1.

The power module shown in FIG. 4b is of a 3DC architecture design. The input 2 includes two first input terminals 21 and one second input terminal 22, and the second input terminal 22 is arranged between the two first input terminals 21 in the first direction A1. The first switch component group G1 and the second switch component group G2 are arranged in the second direction A2, both the first switch component group G1 and the second switch component group G2 are routed and arranged leftward in the first direction A1, and the power module has a large size in the second direction A2. In addition, to connect the first switch component group G1 to the two first input terminals 21, circuit wiring needs to be further arranged on two sides of a bottom plate 11 in the first direction A1, occupying a size of the power module in the first direction A1.

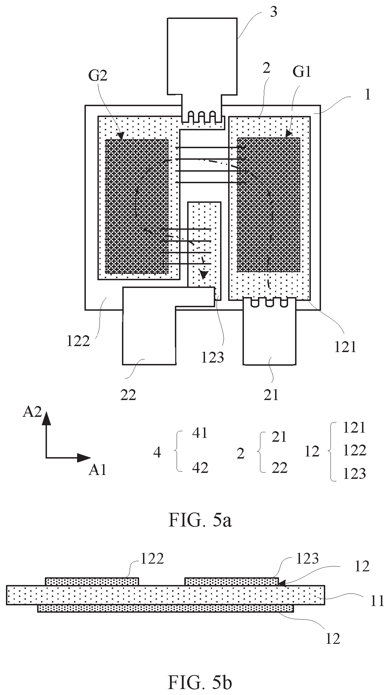

With development of science and technology, design of a power module needs to achieve both low parasitic inductance and a miniaturized design. This application provides a power module shown in FIG. 5a, to ensure that a size of the power module is not increased or even is reduced while the parasitic inductance is reduced, so that an application requirement is met.

FIG. 5a is a diagram of a structural layout of a power module according to an embodiment of this application. For ease of illustration, a structure of a package body 5 is omitted. For example, a conductive layer 12 of a substrate 1 includes a plurality of metal layers that are isolated from each other, and the plurality of metal layers include a first metal layer 121, a second metal layer 122, and a third metal layer 123. A power switch component 4 includes two switch component groups. A first switch component group G1 and a second switch component group G2 are spaced apart in a first direction A1, the first switch component group G1 and the second switch component group G2 are opposite to each other in the first direction A1, and there is a gap between two groups of structures. The first switch component group G1 is disposed on the first metal layer 121, and the second switch component group G2 is disposed on the second metal layer 122. Based on a case in which positions of the first switch component group G1 and the second switch component group G2 are opposite to each other in the first direction A1, an area that is of the first metal layer 121 and that is configured to carry a plurality of first switch component group G1 and an area that is of the second metal layer 122 and that is configured to carry the second switch component group G2 are spaced apart in the first direction A1. The third metal layer 123 is arranged between the first switch component group G1 and the second switch component group G2 in the first direction A1.

Each switch component includes a first electrode and a second electrode, and the switch component may be connected in series in a circuit through the first electrode and the second electrode. Specifically, the first switch component group G1 is disposed on the first metal layer 121, a first electrode of each switch component in the first switch component group G1 is connected to the first metal layer 121, and a second electrode of each switch component in the first switch component group G1 is connected to the second metal layer 122. The second switch component group G2 is disposed on the second metal layer 122, a first electrode of each switch component in the second switch component group G2 is connected to the second metal layer 122, and a second electrode of each switch component in the second switch component group G2 is connected to the third metal layer 123. A first input terminal 21 is connected to the first metal layer 121, and a second input terminal 22 is configured to connect to the third metal layer 123. An output 3 is connected to the second metal layer 122, and the output 3 is configured to output an alternating current.

In the power module shown in FIG. 5a, the first switch component group G1, the second metal layer 122, the second switch component group G2, and the third metal layer 123 are sequentially connected to form a bridge arm circuit. The first metal layer 121, the first switch component group G1, and the second metal layer 122 may be sequentially electrically connected to form an upper bridge arm between the first input terminal 21 and the output 3, the second metal layer 122, the second switch component group G2, and the third metal layer 123 may be sequentially electrically connected to form a lower bridge arm between the second input terminal 22 and the output 3, and the second metal layer 122 is configured to form a bridge arm midpoint.

Still refer to FIG. 5a. An example in which the first input terminal 21 is connected to a positive electrode of a power supply and the second input terminal 22 is connected to a negative electrode of the power supply is used, and a dashed line with an arrow shows an example of a current loop connected to the positive electrode and the negative electrode of the power supply. Because the first switch component group G1 and the second switch component group G2 are spaced apart in the first direction, current directions of a current path corresponding to the first switch component group G1 and a current path corresponding to the second switch component group G2 are opposite to each other, so that parasitic inductance in the current loop can be reduced, and impact of the parasitic inductance on a function of the power module can be reduced. In the first direction A1, circuit wiring of the first switch component group G1 extends toward the second switch component group G2 to connect to the second metal layer 122, and circuit wiring of the second switch component group G2 extends toward the first switch component group G2 to connect to the third metal layer 123, so that the first switch component group G1 and the second switch component group G2 can mutually use the gap between the first switch component group G1 and the second switch component group G2 for circuit wiring. This helps reduce a size of the power module in the first direction A1. In addition, circuit wiring of the bridge arm circuit does not need to occupy space on two sides of the substrate 1 in the first direction A1, and does not increase the size of the power module in the first direction A1.

It can be learned that, in the power module provided in this embodiment of this application, a switch component of the upper bridge arm and a switch component of the lower bridge arm in the bridge arm circuit are arranged in the first direction A1, to connect to one input terminal through the third metal layer between the switch component of the upper bridge arm and the switch component of the lower bridge arm, so that the parasitic inductance in the current loop connected to the power supply can be reduced, to help reduce the size of the power module in the first direction A1. In some embodiments, the size of the power module in the first direction A1 is equivalent to sizes of the power modules shown in FIG. 4a and FIG. 4b in the first direction A1, and a size of the power module in a second direction A2 is equivalent to a size of the power module shown in FIG. 4a in the second direction A2 and is less than the size of the power module shown in FIG. 4b in the second direction A2, so that parasitic inductance generated in a circuit formed by the power module can be reduced to less than parasitic inductance of the power modules shown in FIG. 4a and FIG. 4b, and design requirements for low parasitic inductance and miniaturization can be both achieved.

FIG. 5b shows an example of a partial structure of the power module. The substrate 1 is a double-sided copper clad laminate, and two conductive layers 12 are respectively disposed on two surfaces of a bottom plate 11. One of the conductive layers 12 includes a plurality of metal layers, and the plurality of metal layers are disposed on a same layer. In other words, each metal layer is attached and fastened to a same surface of the bottom plate 11. During preparation of the substrate 1, the plurality of metal layers may be prepared on the same layer in a manner such as etching, to simplify a preparation process. The plurality of metal layers include the foregoing second metal layer 122 and the foregoing third metal layer 123. The second metal layer 122 and the third metal layer 123 are spaced apart on a same surface of the bottom plate 11 in a same-layer arrangement manner.

In a specific layout design of the power module provided in this embodiment of this application, structures may be properly adjusted and designed as required. The following describes, based on a specific design structure of the power module by using examples, the power module provided in this embodiment of this application.

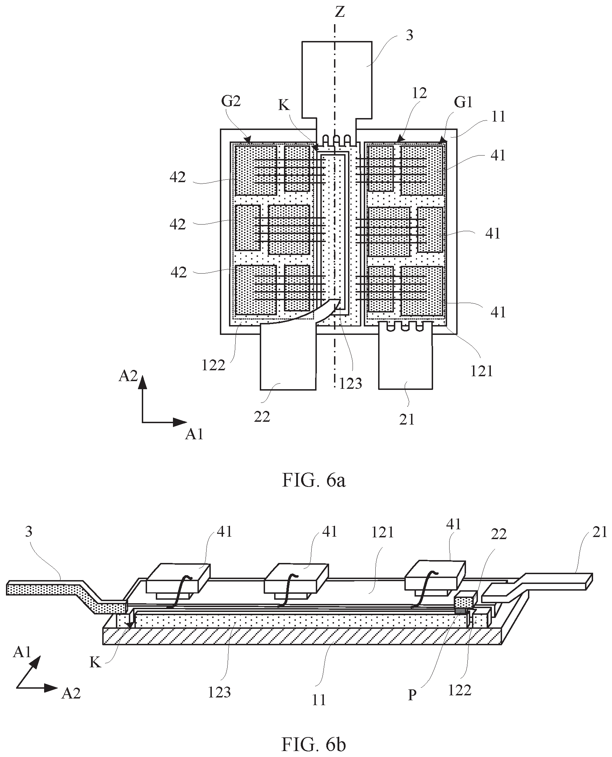

FIG. 6a shows an example of a power module with a 2DC architecture design, which includes one positive input terminal and one negative input terminal. As shown in FIG. 6a, the power switch component 4 includes a plurality of first switch components 41 and a plurality of second switch components 42. The plurality of first switch components 41 are disposed on the first metal layer 121, and the plurality of second switch components 42 are disposed on the second metal layer 122. The plurality of first switch components 41 form the first switch component group G1, the plurality of second switch components 42 form the second switch component group G2, and there is the gap between two groups of structures. The first metal layer 121, the plurality of first switch components 41, and the second metal layer 122 may be electrically connected to form the upper bridge arm between the first input terminal 21 and the output 3, and the second metal layer 122, the plurality of second switch components 42, and the third metal layer 123 may be electrically connected to form the lower bridge arm between the second input terminal 22 and the output 3. In the second direction A2, the first input terminal 21 and the first switch component group G1 are opposite to each other, and the second input terminal 22 and the second switch component group G2 are opposite to each other.

In an embodiment, the plurality of first switch components 41 included in the first switch component group G1 and the plurality of second switch components 42 included in the second switch component group G2 are distributed axisymmetrically about the second direction A2, so that the parasitic inductance can be further reduced.

In some embodiments, based on a solution in which the second metal layer 122 and the third metal layer 123 are disposed on a same layer, the second metal layer 122 includes a notch, the third metal layer 123 is accommodated in the notch, and there is a gap between the second metal layer 122 and the third metal layer 123. In a direction perpendicular to the substrate 1, an orthographic projection of the second metal layer 122 on the bottom plate 11 does not overlap an orthographic projection of the third metal layer 123 on the bottom plate 11. The notch may be implemented in a manner of penetrating the second metal layer 122 to form a hollow, or may be implemented in a manner of omitting material at an edge of the second metal layer 122 to form a groove. The third metal layer 123 is accommodated in the notch, so that the third metal layer 123 structurally avoids contact with the second metal layer 122.

As shown in FIG. 6a, in an embodiment, the second metal layer 122 includes a hollow area K, and the third metal layer 123 is located in the hollow area K. The second input terminal 22 is connected to an end that is of the third metal layer 123 and that is away from the output 3. In the first switch component group G1, at least a part of the first switch components 41 are spaced apart in the second direction A2, a second electrode of each first switch component 41 performs circuit wiring to a side of the plurality of second switch components 42 in the first direction A1 to connect to the second metal layer 122, a part that is of the second metal layer 122 and that is configured to connect to the first switch component 41 is located between the third metal layer 123 and the first metal layer 121, and positions at which the plurality of first switch components 41 are connected to the second metal layer 122 are spaced apart in the second direction A2. At least a part of the second switch components 42 are spaced apart in the second direction A2, a second electrode of each second switch component 42 performs circuit wiring to a side of the plurality of first switch components 41 in the first direction A1 to connect to the third metal layer 123, and positions at which the plurality of second switch components 42 are connected to the third metal layer 123 are spaced apart in the second direction A2. The positions at which second electrodes of the plurality of first switch components 41 are connected to the second metal layer 122 and the positions at which the plurality of second switch components 42 are connected to the third metal layer 123 are arranged in the first direction A1.

In an embodiment, in the first direction A1, one first switch component 41 and one second switch component 42 are opposite to each other, and a position at which a second electrode of the first switch component 41 is connected to the second metal layer 122 and a position at which the second switch component 42 is connected to the third metal layer 123 are opposite to each other.

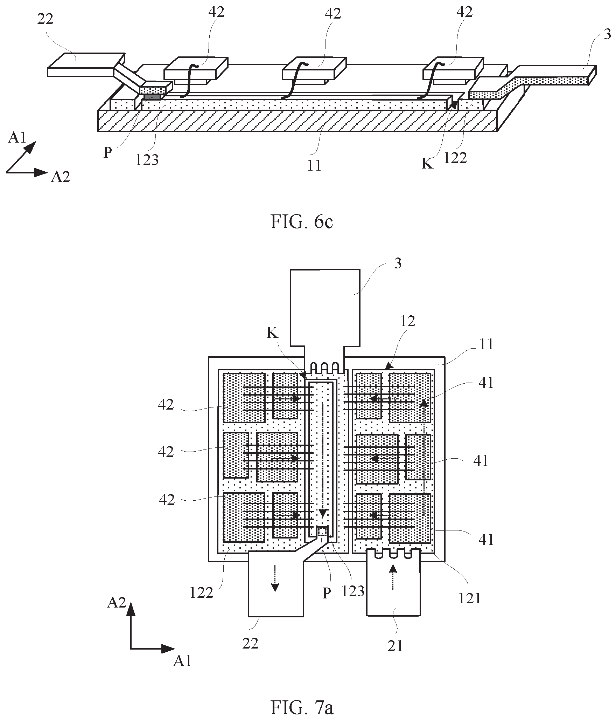

The power module is sectioned along a position of a section line Z in FIG. 6a, to obtain diagrams of cross-sectional structures shown in FIG. 6b and FIG. 6c. FIG. 6b shows a cross-sectional view of a structure on a side of the first input terminal 21 in the first direction A1, and FIG. 6c shows a cross-sectional view of a structure on a side of the second input terminal 22 in the first direction A1. For ease of illustration, structures of switch components, the output 3, and the first input terminal 21 are simplified.

With reference to FIG. 6a, as shown in FIG. 6b and FIG. 6c, the plurality of first switch components 41 are disposed on the first metal layer 121, a first electrode of each first switch component 41 is connected to the first metal layer 121, the second electrode of each first switch component 41 is connected to the second metal layer 122, and the part of the second metal layer 122 is located between the third metal layer 123 and the first metal layer 121 in the first direction A1. The plurality of second switch components 42 are disposed on the second metal layer 122, a first electrode of each second switch component 42 is connected to the second metal layer 122, and the second electrode of each second switch component 42 is configured to connect to the third metal layer 123. The first electrode of each first switch component 41 may be fastened to the first metal layer 121 by using a pressure-assisted silver sintering process, and the first electrode is electrically connected to the first metal layer 121. The second electrode of each first switch component 41 may be connected to the second metal layer 122 through a lead, a copper bar, a bonding wire, or the like. Similarly, the first electrode of each second switch component 42 may be fastened to the second metal layer 122 by using the pressure-assisted silver sintering process, and the first electrode is electrically connected to the second metal layer 122. The second electrode of each second switch component 42 may be connected to the third metal layer 123 through a lead, a copper bar, a bonding wire, or the like. In a thickness direction of the substrate 1, the second input terminal 22 is connected to a surface that is of the third metal layer 123 and that is away from the bottom plate 11.

In an example, all the third metal layer 123, the first metal layer 121, and the second metal layer 122 are several metal layers among the plurality of metal layers of the conductive layer 12. During the preparation of the substrate 1, the third metal layer 123, the first metal layer 121, and the second metal layer 122 may be simultaneously prepared by using a same process. The third metal layer 123, the first metal layer 121, and the second metal layer 122 are of metal structures and have a same thickness. It can be learned from FIG. 6a to FIG. 6c that a projection of the second input terminal 22 on the substrate 1 partially overlaps the second metal layer 122 in the thickness direction of the substrate 1. To prevent the second input terminal 22 from being in contact with a metal layer other than the third metal layer 123, a spacing between the second input terminal 22 and the bottom plate 11 is greater than a thickness of the conductive layer 12, so that there is a gap between the second input terminal 22 and the second metal layer 122 in the thickness direction of the substrate 1, and therefore, the second input terminal 22 can avoid the second metal layer 122. In a specific example, the second input terminal 22 is connected to the third metal layer 123 through a pad P, and a height of the pad P may allow a gap between the second input terminal 22 and the conductive layer 12, to prevent the second input terminal 22 from being connected to the metal layer other than the third metal layer 123. A position of the pad P is a position at which the third metal layer 123 and the second input terminal 22 are soldered.

Based on power modules shown in FIG. 6a to FIG. 6c, as shown in FIG. 7a, an example in which the first input terminal 21 is connected to the positive electrode of the power supply and the second input terminal 22 is connected to the negative electrode of the power supply is used, and dashed lines with arrows indicate current paths at a plurality of positions included in a bridge arm circuit formed by the power module. The first switch component group G1 including the plurality of first switch components 41 and the second switch component group G2 including the plurality of second switch components 42 are opposite to each other in the first direction A1, and positions of the first switch component group G1 and the second switch component group G2 are symmetrical about the second direction A2. A current path of the first metal layer 121 is from a side of the first input terminal 21 toward a side of the output terminal 3 in the second direction A2 for electrical connection to the plurality of first switch components 41 arranged in the second direction A2. A current path toward the plurality of second switch components 42 in the first direction A1 is formed between each first switch component 41 and the second metal layer 122. A current path of the second metal layer 122 is from the side of the output 3 toward a side of the second input terminal 22 in the second direction A2 for electrical connection to the plurality of second switch components 42 arranged in the second direction A2. A current path toward the first switch component group G1 in the first direction A1 is formed between each second switch component 42 and the third metal layer 123. A current path of the third metal layer 123 is from the side of the output 3 toward a side of the second input terminal 22 in the second direction A2. The plurality of first switch components 41 are connected in parallel in a circuit connection between the first metal layer 121 and the second metal layer 122, and the plurality of second switch components 42 are connected in parallel in a current connection between the second metal layer 122 and the third metal layer 123. A current loop of the entire power module includes at least two current paths whose current directions are opposite to each other, so that parasitic inductance in the current loop can be reduced, and impact of the parasitic inductance on the function of the power module can be reduced. In the first direction A1, both circuit wiring between the second electrode of each first switch component 41 and the second metal layer 122 and circuit wiring in which the second electrode of each second switch component 42 is connected to the third metal layer 123 may use space between the first switch component group G1 and the second switch component group G2, and do not need to occupy the space on the two sides of the substrate 1 in the first direction A1, to help reduce the size of the power module in the first direction A1.

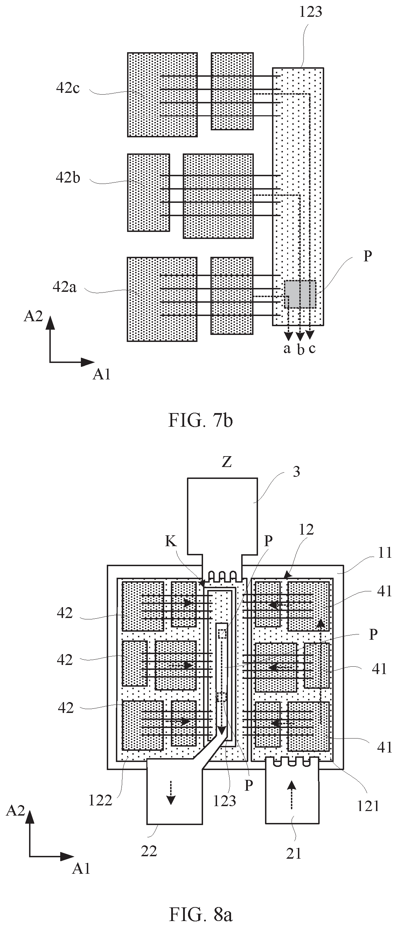

With reference to FIG. 7a, FIG. 7b shows a current path at which currents of the plurality of second switch components 42 are combined through the third metal layer 123 and then transmitted to the second input terminal 22. The position at which the third metal layer 123 and the second input terminal 22 are soldered is close to an end that is of the third metal layer 123 in the second direction A2, and all the plurality of second switch components 42 are connected to the second input terminal 22 through the soldering position. Current paths from different second switch components 42 to the second input terminal 22 through the third metal layer 123 are different.

Refer to FIG. 7a and FIG. 7b together. Three second switch components 42 are used as an example. In the second direction A2, a second switch component 42a, a second switch component 42b, and a second switch component 42c are sequentially arranged in a direction from the second input terminal 22 to the output 3, the second switch component 42a is close to the second input terminal 22, and the second switch component 42c is close to the output 3. A current path a of a current of the second switch component 42a to the second input terminal 22 through the third metal layer 123 is shorter than a current path b of a current of the second switch component 42b to the second input terminal 22 through the third metal layer 123, and the current path b of the current of the second switch component 42b to the second input terminal 22 through the third metal layer 123 is shorter than a current path c of a current of the second switch component 42c to the second input terminal 22 through the third metal layer 123.

FIG. 8a shows an example of another power module. A third metal layer 123 in the power module is connected to a second input terminal 22 through a plurality of pads P, and a quantity and positions of the pads P are different from those of the power module shown in FIG. 7a. In an example, in a second direction A2, for three second switch components 42, two pads P are disposed on the third metal layer 123, and one pad P is correspondingly disposed between every two second switch components 42.

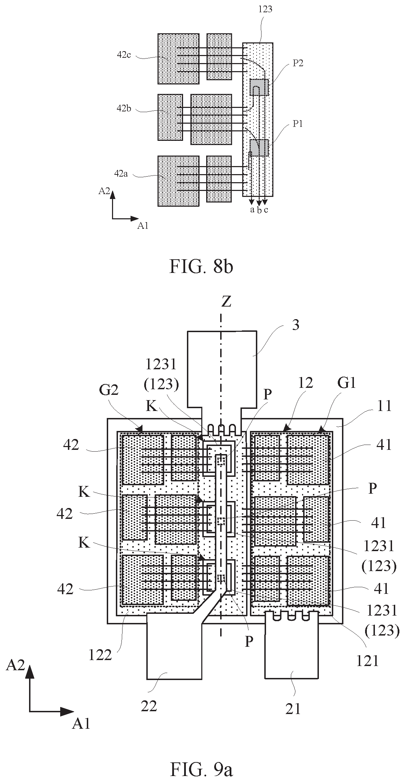

FIG. 8b shows current paths of currents of a plurality of second switch components 42 in the power module in FIG. 8a to the second input terminal 22 through the third metal layer 123.

Refer to FIG. 8a and FIG. 8b together. A second switch component 42a, a second switch component 42b, and a third switch component 42c are used as an example, the second switch component 42a is close to the second input terminal 22, and the second switch component 42c is close to an output 3. In the second direction A2, the two pads P are a pad P1 located between the second switch component 42a and the second switch component 42b and a pad P2 located between the second switch component 42b and the second switch component 42c, respectively. A current path a of the second switch component 42a includes a distance between the second switch component 42a and the pad P2 and a distance between the pad P2 and a side of an input 2. A current path c of the second switch component 42c includes a distance between the second switch component 42c and the pad P1 and a distance between the pad P1 and the side of the input 2. A current path b of the second switch component 42b may be toward the second input terminal 22 through the pad P1, or may be toward the second input terminal 22 through the pad P2. In comparison with FIG. 7b, in the power module shown in FIG. 8b, a difference between lengths of three current paths is smaller. In other words, a difference between current paths of different second switch components 42 to the second input terminal 22 through the third metal layer 123 is reduced, so that a current sharing effect is better.

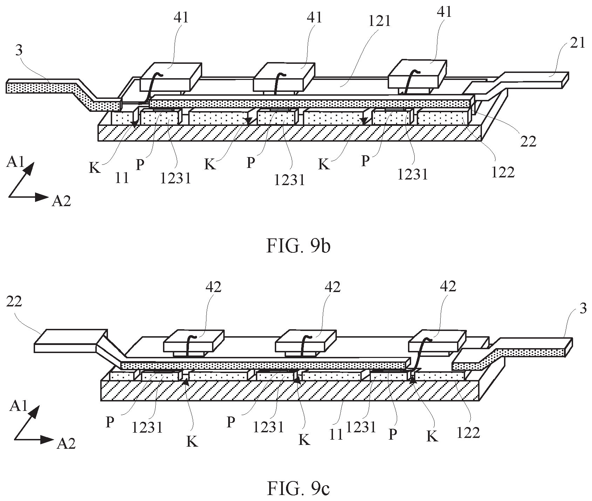

A difference between a power module shown in FIG. 9a and the power module shown in FIG. 6a lies in that, specifically, a third metal layer 123 includes a plurality of third metal islands 1231, and the plurality of third metal islands 1231 are spaced apart in a second direction A2. The power module is sectioned along a position of a section line Z in FIG. 9a, to obtain diagrams of cross-sectional structures shown in FIG. 9b and FIG. 9c. FIG. 9b shows a cross-sectional view of a structure on a side of a first input terminal 21 in a first direction A1, and FIG. 9c shows a cross-sectional view of a structure on a side of a second input terminal 22 in the first direction A1.

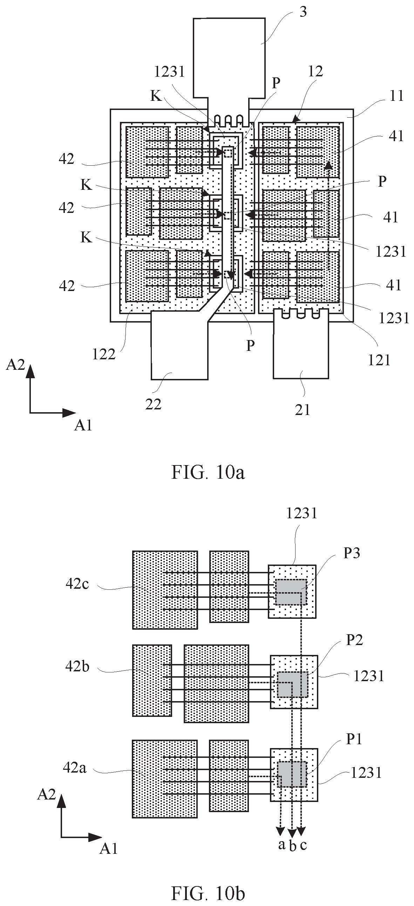

Refer to FIG. 9a to FIG. 9c together. A second metal layer 122 correspondingly includes a plurality of hollow structures K, and each third metal island 1231 is located in one hollow structure K. An end that is of the second input terminal 22 and that faces an output 3 in the second direction A2 extends to between a first switch component group G1 and a second switch component group G2, and circuit connection of the second input terminal 22 to the third metal layer 123 may be implemented through a plurality of pads P in a thickness direction of a substrate 1. The third metal layer 123 is divided into the plurality of isolated third metal islands 1231, to facilitate a layout of electrical connections between a plurality of second switch components 42 and the third metal layer 123, and further improve maintainability. Based on the power module shown in FIG. 9a to FIG. 9c, as shown in FIG. 10a, an example in which the first input terminal 21 is connected to a positive electrode of a power supply and the second input terminal 22 is connected to a negative electrode of the power supply is used, and dashed lines with arrows indicate current paths at a plurality of positions included in a bridge arm circuit formed by the power module. In the first direction A1, the first switch component group G1 and the second switch component group G2 are opposite to each other and are symmetrical in positions. Each second switch component 42 may be connected to the second input terminal 22 through a pad P on one third metal island 1231, to form a current path. A current loop of the entire power module includes at least two current paths whose current directions are opposite to each other, so that parasitic inductance in the current loop can be reduced, and impact of the parasitic inductance on a function of the power module can be reduced. In the first direction A1, both circuit wiring between a second electrode of each first switch component 41 and the second metal layer 122 and circuit wiring in which a second electrode of each second switch component 42 is connected to the third metal island 1231 do not need to occupy space on two sides of the substrate 1 in the first direction A1, to help reduce a size of the power module in the first direction A1.

With reference to FIG. 10a, FIG. 10b shows current paths at which currents of the plurality of second switch components 42 are connected to the second input terminal 22 through the plurality of third metal islands 1231. Current paths of different second switch components 42 to the second input terminal 22 through corresponding third metal islands 1231 are different.

In an example, as shown in FIG. 10b, in the second direction A2, for three second switch components 42, the third metal layer 123 includes three third metal islands 1231, and one pad P configured to connect to the second input terminal 22 is disposed on each third metal island 1231. In the first direction A1, a second switch component 42a corresponds to a pad P1, a second switch component 42b corresponds to a pad P2, and a second switch component 42c corresponds to a pad P3. A current path a of a current of the second switch component 42a to the second input terminal 22 through the pad P1 on the third metal layer 123 is shorter than a current path b of a current of the second switch component 42b to the second input terminal 22 through the pad P2 on the third metal layer 123, and the current path b of the current of the second switch component 42b to the second input terminal 22 through the pad P2 on the third metal layer 123 is shorter than a current path c of a current of the second switch component 42c to the second input terminal 22 through the pad P3 on the third metal layer 123. Current paths of the three second switch components 42 are similar to current paths of the three second switch components 42 shown in FIG. 7b.

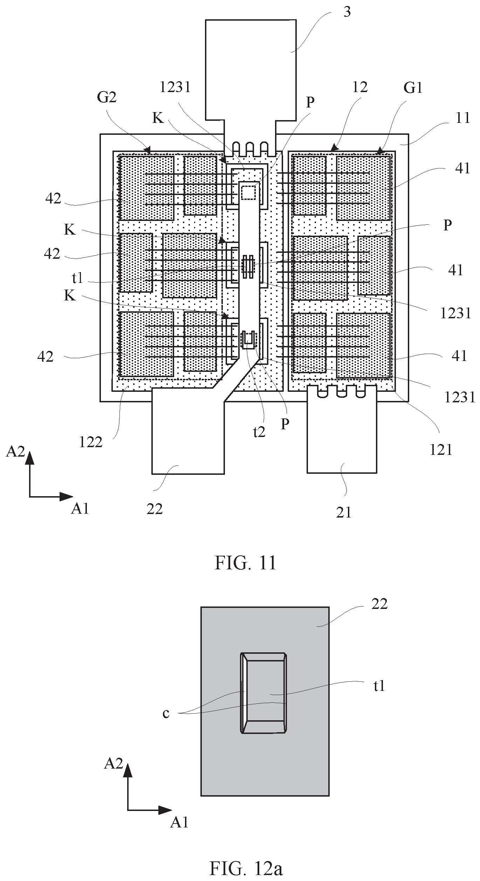

In some embodiments, a difference between a power module shown in FIG. 11 and the power module shown in FIG. 9a lies in that an elastomer is designed at a position of a second input terminal 22 for connecting to a pad P, and elastic connection to the pad P is implemented through the elastomer, so that connection reliability is higher. In an embodiment, the second input terminal 22 includes a body and at least one elastomer configured to connect to a third metal layer 123. Each elastomer is connected to the body in one end or two ends of the second direction A1, and each elastomer protrudes, in a thickness direction of a substrate 1, from a surface that is of the body and that faces the third metal layer 123. The second input terminal 22 is connected to the third metal layer 123 through the elastomer, so that the connection reliability can be enhanced while meeting a good electrical connection requirement. The elastomer extends in the second direction and is connected to the third metal layer 123, and a current path of a current to the second input terminal 22 through the elastomer varies. In a structure design of the power module, structures of second switch components 42 at different positions and the elastomer are designed in combination, so that a difference between current paths of different second switch components 42 can be reduced, and a current sharing effect can be improved.

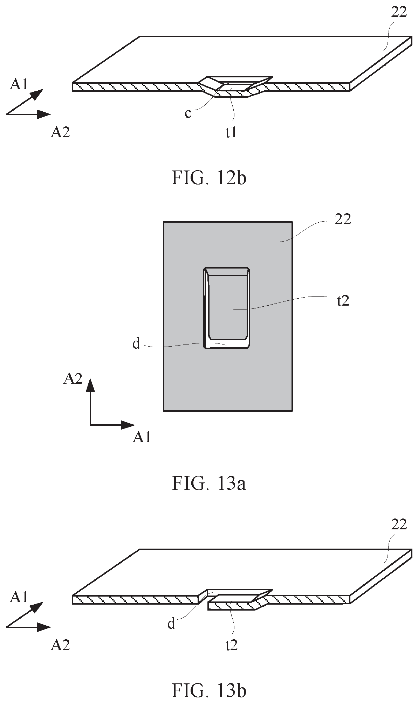

In an example, in FIG. 11, the second input terminal 22 includes two elastomer structures. For a structure of an elastomer structure t1, refer to FIG. 12a and FIG. 12b. For a structure of an elastomer structure t2, refer to FIG. 13a and FIG. 13b.

With reference to FIG. 12a and FIG. 12b, the second input terminal 22 has two parallel strip grooves c, each strip groove c penetrates the second input terminal 22 in a thickness direction of the second input terminal 22, the elastomer structure t1 is formed between the two strip grooves c, and a structure that is of the second input terminal 22 and that is other than the elastomer structure t1 is the body. Structure variation is performed on the elastomer structure t1, so that a middle position of the elastomer structure t1 can sink toward a side of the pad P to form a downward protruding structure, to facilitate connection of the elastomer structure t1 to the pad P.

In some embodiments, a length direction of each strip groove c is parallel or approximately parallel to the second direction A2, so that a length direction of the elastomer structure t1 is parallel to the second direction A2. When the second input terminal 22 is connected to the pad P through the elastomer structure t1, a current path is related to the length direction of the elastomer structure t1. Based on an arrangement of the plurality of second switch components 42 in the second direction A2, a current path at which the second switch component 42 is connected to the second input terminal 22 through the pad P may be changed through the elastomer structure t1.

With reference to FIG. 13a and FIG. 13b, the second input terminal 22 has a U-shaped groove d, and the U-shaped groove d penetrates the second input terminal 22 in a thickness direction of the second input terminal 22, so that the second input terminal 22 forms a cantilever beam-type elastomer structure t2, and a structure that is of the second input terminal 22 and that is other than an elastomer structure t2 is the body. Structure variation is performed on the elastomer structure t2, so that a free end of the elastomer structure t2 can sink toward a side of the pad P to form a downward protruding structure, to facilitate connection of the elastomer structure t2 to the pad P.

In some embodiments, a groove opening direction of the U-shaped groove d is parallel or approximately parallel to the second direction A2, so that a length direction of the elastomer structure t2 is parallel to the second direction A2. When the second input terminal 22 is connected to the pad P through the elastomer structure t2, a current path is related to the length direction of the elastomer structure t2. Based on an arrangement of the plurality of second switch components 42 in the second direction A2, a current path at which the second switch component 42 is connected to the second input terminal 22 through the pad P may be changed through the elastomer structure t2.

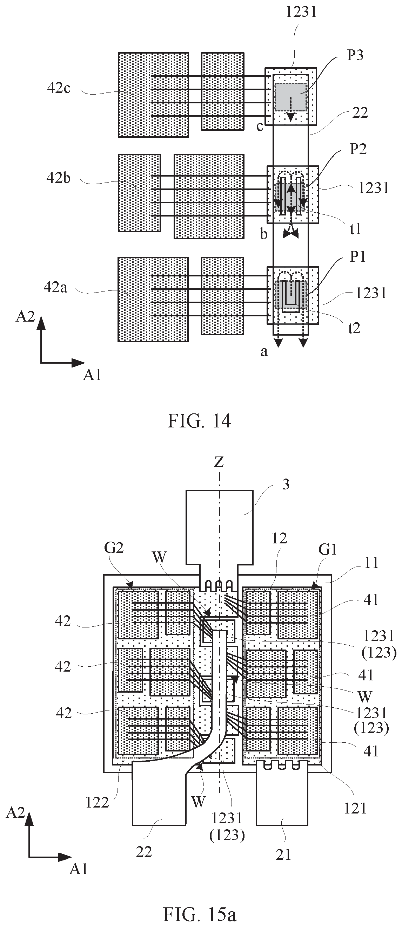

FIG. 14 shows current paths at which currents of the plurality of second switch components 42 in the power module shown in FIG. 11 are connected to the second input terminal 22 through a plurality of third metal islands 1231.

In an example, as shown in FIG. 14, in the second direction A2, for three second switch components 42, the third metal layer 123 includes three third metal islands 1231, and one pad P configured to connect to the second input terminal 22 is disposed on each third metal island 1231. In the first direction A1, a second switch component 42a corresponds to a pad P1, a second switch component 42b corresponds to a pad P2, and a second switch component 42c corresponds to a pad P3.

One elastomer structure t2 is disposed on the second input terminal 22 corresponding to the pad P1, and the second switch component 42a is connected to the second input terminal 22 through the pad P1 and the elastomer structure t2 to form a current path a. The current path a includes a distance between the second switch component 42a and the pad P1, a length of the elastomer structure t2 in the second direction A2, and a distance from an end that is of the elastomer structure t2 and that faces an output 3 to a side of an input 2.

One elastomer structure t1 is disposed on the second input terminal 22 corresponding to the pad P2, and the second switch component 42b is connected to the second input terminal 22 through the pad P2 and the elastomer structure t1 to form a current path b. The current path b may include a distance between the second switch component 42b and the pad P2, a distance from a position at which the elastomer structure t1 is connected to the pad P2 in the second direction A2 to the end that is of the elastomer structure t1 and that faces the output 3, and the distance from the end that is of the elastomer structure t1 and that faces the output 3 to the side of the input 2. The current path b may also include a distance between the second switch component 42b and the pad P2 and a distance from the position at which the elastomer structure t1 is connected to the pad P2 in the second direction A2 to the side of the input 2.

In comparison with FIG. 10b, in a power module shown in FIG. 14, a difference between lengths of three current paths is smaller. In other words, a difference between current paths of different second switch components 42 to the second input terminal 22 through the third metal layer 123 is reduced, so that a current sharing effect is better.

For a power module shown in FIG. 15a, a difference between the power module and the power module shown in FIG. 9a lies in that positions at which second electrodes of a plurality of first switch components 41 are connected to a second metal layer 122 and positions at which a plurality of second switch components 42 are connected to a third metal layer 123 are alternately distributed in a second direction A2, and share space between a first switch component group G1 and a second switch component group G2.

Specifically, as shown in FIG. 15a, the third metal layer 123 includes a plurality of third metal islands 1231, and the plurality of third metal islands 1231 are spaced apart in the second direction A2. A second electrode of each second switch component 42 is routed to a side of the plurality of first switch components 41 in a first direction A1 to connect to one third metal island 1231. Correspondingly, an edge that is of the second metal layer 122 and that faces the first switch component group G1 in the first direction A1 includes notches shown in an example of a plurality of grooves W, and the plurality of grooves W are spaced apart in the second direction A2. Each third metal island 1231 is located in one groove W.

In the second direction A2, a protruding part that is of the second metal layer 122 and that is adjacent to one groove W is configured to connect to at least one first switch component 41. It may be considered that the positions at which the second electrodes of the plurality of first switch components 41 are connected to the second metal layer 122 and the plurality of third metal islands 1231 are alternately distributed, to share the space between the first switch component group G1 and the second switch component group G2.

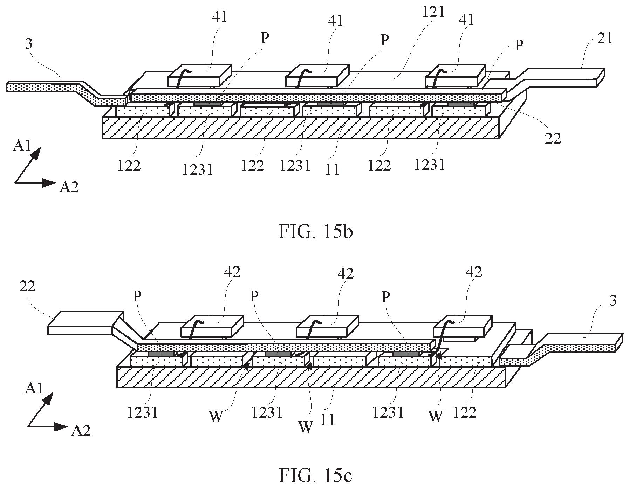

The power module is sectioned along a position of a section line Z in FIG. 15a, to obtain diagrams of cross-sectional structures shown in FIG. 15b and FIG. 15c. FIG. 15b shows a cross-sectional view of a structure on a side of a first input terminal 21 in the first direction A1, and FIG. 15c shows a cross-sectional view of a structure on a side of a second input terminal 22 in the first direction A1.

With reference to FIG. 15a, as shown in FIG. 15b and FIG. 15c together, in the first direction A1, one third metal island 1231 is accommodated in each of the plurality of grooves W on a side that is of the second metal layer 122 and that faces the first metal layer 121, and all the plurality of third metal islands 1231 are connected to the second input terminal 22. In a thickness direction of a substrate 1, the second input terminal 22 is connected to a surface that is of each third metal island 1231 and that is away from a bottom plate 11.

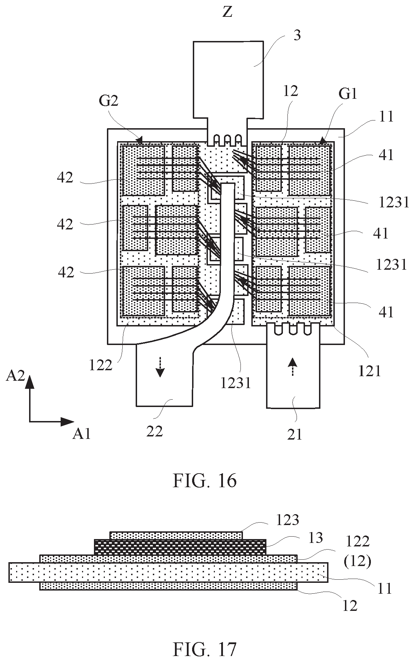

Based on the power module shown in FIG. 15a to FIG. 15c, as shown in FIG. 16, an example in which the first input terminal 21 is connected to a positive electrode of a power supply and the second input terminal 22 is connected to a negative electrode of the power supply is used, and current paths at a plurality of positions included in a bridge arm circuit formed by the power module are indicated by dashed lines with arrows. A current loop of the entire power module includes current paths whose current directions are opposite to each other, so that parasitic inductance in the current loop can be reduced, and impact of the parasitic inductance on a function of the power module can be reduced. The position at which the second electrode of each first switch component 41 is connected to the second metal layer 122 and the position at which each second switch component 42 is connected to the third metal island 1231 are located between the first switch component group G1 and the second switch component group G2 in the first direction A1, so that circuit wiring does not need to occupy space on two sides of the substrate 1 in the first direction A1. The positions at which the second electrodes of the plurality of first switch components 41 are connected to the second metal layer 122 and the positions at which the plurality of second switch components 42 are connected to the third metal islands 1231 are alternately distributed in the second direction A2, so that circuit wiring can be facilitated without increasing a size of the power module in the first direction A1.

In some embodiments, among a plurality of metal layers that are isolated from each other and that are included in the substrate 1, different metal layers are stacked. In a direction perpendicular to the substrate 1, one metal sub-layer is arranged on a side of another metal sub-layer in a thickness direction, and two stacked metal layers are isolated from each other by using an insulating material. In the power module provided in this embodiment of this application, as shown in FIG. 17, a third metal layer 123 and a second metal layer 122 may alternatively be implemented in a stacking manner. A substrate 1 includes a bottom plate 11 and conductive layers 12 disposed on two sides of the bottom plate 11, and one of the conductive layers 12 includes the second metal layer 122. The substrate 1 further includes the third metal layer 123. The third metal layer 123 is disposed, in a thickness direction of the bottom plate 11, on a side that is of the second metal layer 122 and that is away from the bottom plate 11. An insulation layer 13 is disposed between the third metal layer 123 and the second metal layer 122 to insulate and isolate the third metal layer 123 from the second metal layer 122.

The following describes some embodiments about the power module based on a manner in which the third metal layer 123 and the second metal layer 122 are stacked.

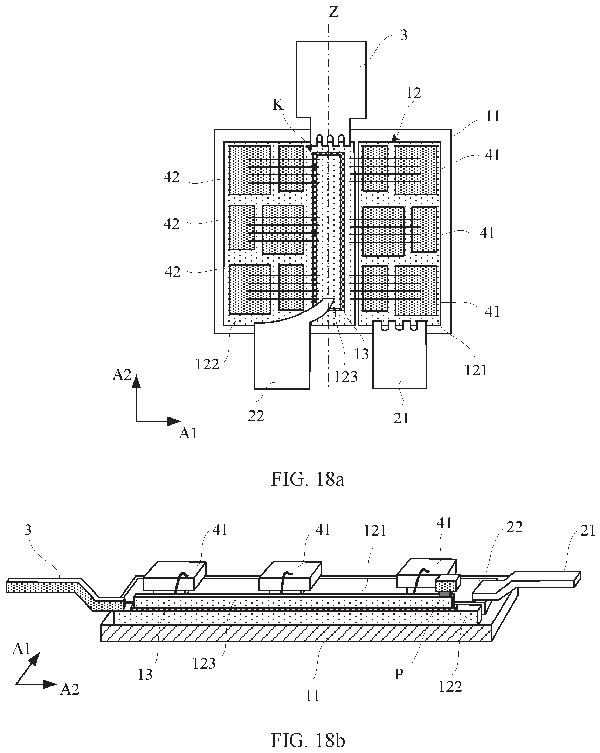

A difference between a power module shown in FIG. 18a and the power module provided in FIG. 6a lies in that a third metal layer 123 is stacked on a surface that is of a second metal layer 122 and that is away from a bottom plate 11, and the third metal layer 123 is insulated from the second metal layer 122 through an insulation layer 13. In a direction perpendicular to a substrate 1, an orthographic projection of the third metal layer 123 on the bottom plate 11 at least partially overlaps an orthographic projection of the second metal layer 122 on the bottom plate 11. On a surface that is of the substrate 1 and that is configured to dispose a first switch component 41 and a second switch component 42, the third metal layer 123 and the second metal layer 122 share a part of space in a stacking manner. This helps reduce sizes of the power module in a first direction A1 and a second direction A2.

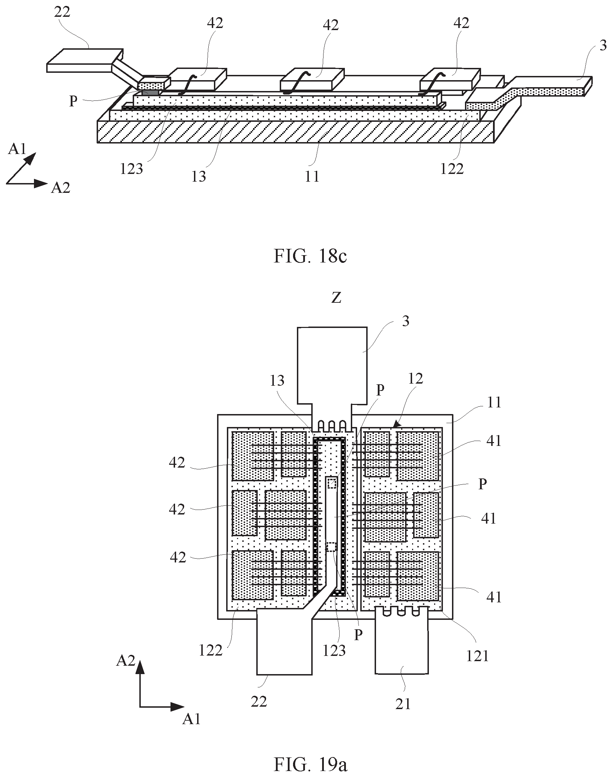

The power module is sectioned along a position of a section line Z in FIG. 18a, to obtain diagrams of cross-sectional structures shown in FIG. 18b and FIG. 18c. FIG. 18b shows a cross-sectional view of a structure on a side of a plurality of first switch components 41 in the first direction A1, and FIG. 18c shows a cross-sectional view of a structure on a side of a plurality of second switch components 42 in the first direction A1.

With reference to FIG. 18a, as shown in FIG. 18b and FIG. 18c together, on a plane perpendicular to the first direction A1 and the second direction A2, the third metal layer 123 is stacked on a side that is of the second metal layer 122 and that is away from the bottom plate 11, and the third metal layer 123 is insulated and isolated from the second metal layer 122 through the insulation layer 13. In a thickness direction of the substrate 1, a spacing between the third metal layer 123 and the bottom plate 11 is greater than a thickness of the second metal layer 122. A second input terminal 22 may be connected to the third metal layer 123 through a pad P in the thickness direction of the substrate 1, or the second input terminal 22 may be directly connected to the third metal layer 123, and the second input terminal 22 avoids the second metal layer 122.

A current path of a bridge arm circuit of the power module shown in FIG. 18a to FIG. 18b is similar to the current path of the bridge arm circuit of the power module shown in FIG. 7a. Examples are not described herein again.

Using the power module shown in FIG. 18a as a reference, FIG. 19a to FIG. 19c show several structure variations of the power module. A common point of the structure variations is that the third metal layer 123 is stacked on the side that is of the second metal layer 122 and that is away from the bottom plate 11, and the third metal layer 123 is insulated from the second metal layer 122 through the insulation layer 13.

A difference between a power module shown in FIG. 19a and the power module shown in FIG. 18a lies in that, in an example, in a second direction A2, for three second switch components 42, two pads P are disposed on a third metal layer 123, and one pad P is correspondingly disposed between every two second switch components 42. A current path of a bridge arm circuit of the power module is similar to a current path of a bridge arm circuit of the power module shown in FIG. 8a. A difference between lengths of current paths of different second switch components 42 to a side of an input 2 is small, and a current sharing effect is better.

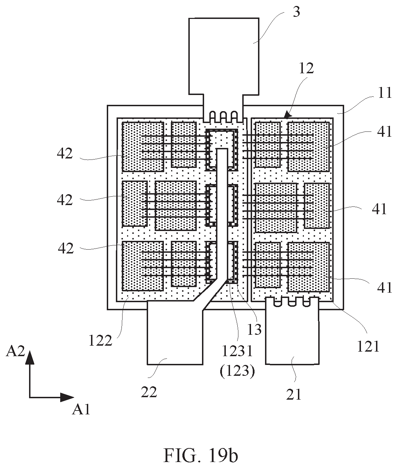

A difference between a power module shown in FIG. 19b and the power module shown in FIG. 18a lies in that a third metal layer 123 includes a plurality of third metal islands 1231, and the plurality of third metal islands 1231 are spaced apart in a second direction A2. Each third metal island 1231 is stacked on a side that is of a second metal layer 122 and that is away from a bottom plate 11, and each third metal island 1231 is insulated from the second metal layer 122 through an insulation layer 13. A current path of a bridge arm circuit of the power module is similar to a current path of a bridge arm circuit of the power module shown in FIG. 10a.

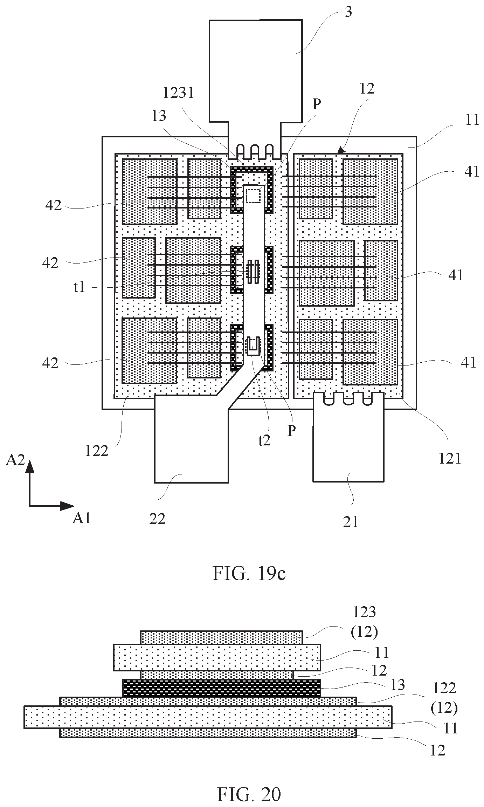

A difference between a power module shown in FIG. 19c and the power module shown in FIG. 19b lies in that an elastomer is designed at a position of a second input terminal 22 for connecting to a third metal layer 123, and elastic connection to a pad P is implemented through the elastomer, so that connection reliability is higher. For an elastomer structure t1 and an elastomer structure t2, refer to the power module shown in FIG. 11. A current path at which a second switch component 42 is connected to the second input terminal 22 through the pad P is changed through the elastomer. A current path of a bridge arm circuit of the power module is similar to a current path of a bridge arm circuit of the power module shown in FIG. 14.

In some embodiments, the substrate 1 is of a stacked structure of a multilayer double-sided copper clad laminate. As shown in FIG. 20, the substrate 1 includes two bottom plates 11, and one conductive layer 12 is disposed on two sides of each bottom plate 11 in a thickness direction. In the thickness direction of the substrate 1, the insulation layer 13 is disposed between a conductive layer 12 that is on an upper-layer bottom plate 11 and that faces a lower-layer bottom plate 11 and a conductive layer 12 that is on the lower-layer bottom plate 11 and that faces the upper-layer bottom plate 11. The conductive layer 12 that is on the lower-layer bottom plate 11 and that faces the upper-layer bottom plate 11 includes the second metal layer 122, and a conductive layer 12 that is on the upper-layer bottom plate 11 and that is away from the lower-layer bottom plate 11 includes the third metal layer 123.

An embodiment of this application further provides some power modules with 3DC architectures. A difference from the foregoing power modules lies in that inputs of these power modules include three input terminals: two positive input terminals and one negative input terminal. Alternatively, the three input terminals may be two negative input terminals and one positive input terminal.

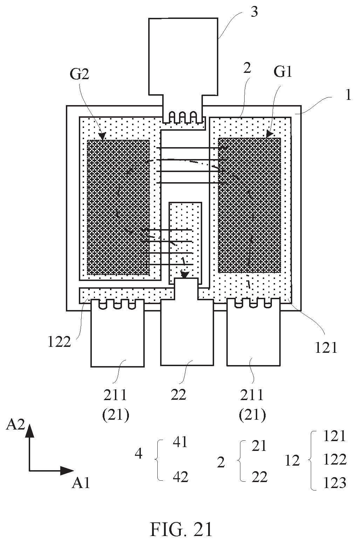

FIG. 21 shows an example of a power module with three input terminals. As shown in FIG. 21, a first input terminal 21 of the power module includes two terminal ends 211, and a second input terminal 22 is arranged between the two terminal ends 211 in a first direction A1. Both the two terminal ends 211 are configured to connect to a first metal layer 121. An example in which the first input terminal 21 is connected to a positive electrode of a power supply and the second input terminal 22 is connected to a negative electrode of the power supply is used, and a dashed line with an arrow shows an example of a current loop connected to the positive electrode and the negative electrode of the power supply. Current directions of a current path corresponding to a first switch component group G1 and a current path corresponding to a second switch component group G2 are opposite to each other, so that parasitic inductance in the current loop can be reduced, and impact of the parasitic inductance on a function of the power module can be reduced. The first switch component group G1 and the second switch component group G2 can mutually use a gap between the first switch component group G1 and the second switch component group G2 to perform circuit wiring. This helps reduce a size of the power module in the first direction A1. In addition, circuit wiring of a bridge arm circuit does not need to occupy space on two sides of the substrate 1 in the first direction A1, and does not increase the size of the power module in the first direction A1.

In the power module shown in FIG. 21, the first switch component group G1 and the second switch component group G2 are spaced apart in the first direction A1, so that use of the three input terminals does not increase a size of the power module, making the size of the power module with three input terminals equivalent to a size of a power module with two input terminals.

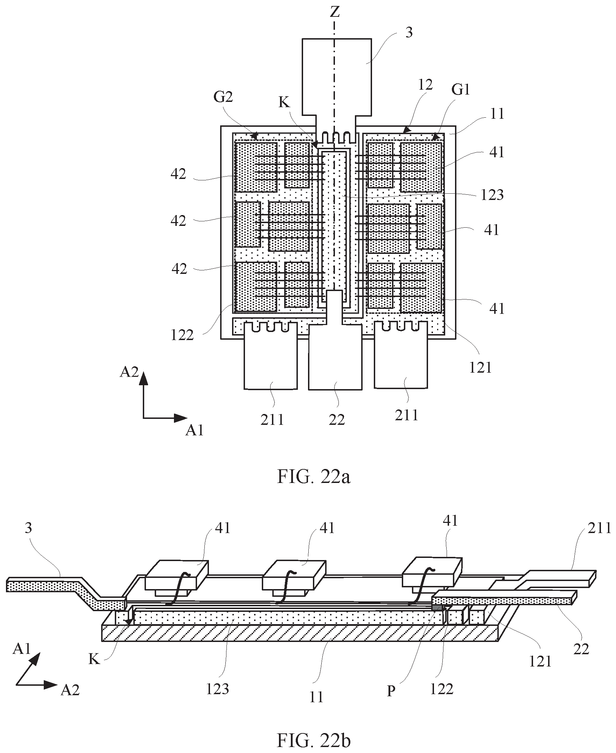

FIG. 22a shows a power module with three input terminals. A structure of the power module is similar to that of the power module shown in FIG. 6a. A difference from the power module shown in FIG. 6a lies in that, in a second direction A2, a first switch component group G1 is opposite to one terminal end 211, a second switch component group G2 is opposite to the other terminal end 211, and a second input terminal 22 is opposite to a third metal layer 123. To connect to two terminal ends 211 of a first input terminal 21, a first metal layer 121 extends, in a first direction A1, to a side that is of a plurality of second switch components 42 and that faces an input 2, so that the first metal layer 121 has a part arranged between a second metal layer 122 and the input 2 in the second direction A2.

In an embodiment, the power module is sectioned along a position of a section line Z in FIG. 22a, to obtain a cross-sectional structure shown in FIG. 22b. FIG. 22b shows a cross-sectional view of a structure on a side of a plurality of first switch components 41 in the first direction A1.

With reference to FIG. 22a and FIG. 22b, in a thickness direction of a substrate 1, a projection of the second input terminal 22 on the substrate 1 partially overlaps the second metal layer 122 and the first metal layer 121. To prevent the second input terminal 22 from being in contact with a metal layer other than the third metal layer 123, a spacing between the second input terminal 22 and a bottom plate 11 is greater than a thickness of a conductive layer 12. The third metal layer 123 and the first metal layer 121 are disposed on a same layer, and there is a gap between the second input terminal 22 and the conductive layer 12 in the thickness direction of the substrate 1, so that the second input terminal 22 can avoid the second metal layer 122 and the first metal layer 121. In a specific example, the second input terminal 22 is connected to the third metal layer 123 through a pad P, and a height of the pad P may allow the gap between the second input terminal 22 and the conductive layer 12, to prevent the second input terminal 22 from being connected to the metal layer other than the third metal layer 123. A position of the pad P is a position at which the third metal layer 123 and the second input terminal 22 are soldered.

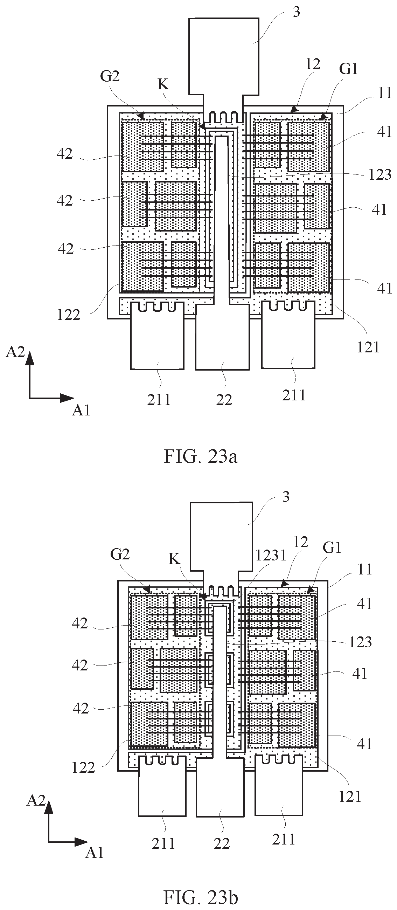

FIG. 23a to FIG. 23c respectively show examples of three power modules with three input terminals. Structures of first metal layers 121 and second input terminals 22 in the three power modules are similar to those of the power module shown in FIG. 22a.

Specifically, in the power module shown in FIG. 23a, an end that is of the second input terminal 22 and that faces an output 3 in a second direction A2 extends to between a first switch component group G1 and a second switch component group G2, and circuit connection of the second input terminal 22 to a third metal layer 123 may be implemented through a plurality of solder points in a thickness direction of a substrate 1. In the power module shown in FIG. 23b, a third metal layer 123 includes, for example, a plurality of third metal islands 1231, and the plurality of third metal islands 1231 are spaced apart in a second direction A2. The second metal layer 122 correspondingly includes a plurality of notches in a form of hollow structure K, and each third metal island 1231 is located in one hollow structure K. In a direction perpendicular to a substrate 1, the hollow structure K is located within a range of a second metal layer 122, the hollow structure K penetrates the second metal layer 122 to expose a part of a bottom plate 11, and each conductive layer 1231 is disposed on an exposed bottom plate 11 of one hollow structure K. Multi-point circuit connection of the second input terminal 22 and the third metal layer 123 to the plurality of third metal islands 1231 is implemented in the thickness direction of the substrate 1.

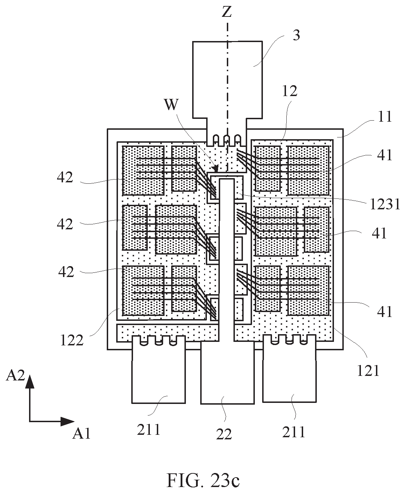

In the power module shown in FIG. 23c, an edge that is of a second metal layer 122 and that faces a plurality of second switch components 42 in a first direction A1 includes a plurality of grooves W, and the plurality of grooves W are spaced apart in a second direction A2. Each third metal island 1231 is located in one groove W. Multi-point circuit connection of the second input terminal 22 and a third metal layer 123 to a plurality of third metal islands 1231 is implemented in a thickness direction of a substrate 1.

It should be understood that, in the power modules shown in FIG. 23a and FIG. 23b, the second input terminal 22 may alternatively be provided with an elastomer structure t1 and an elastomer structure t2 that are shown in FIG. 11 to be electrically connected to the third metal layer 123, and lengths of current paths between second switch components 42 at different positions and the input 2 are changed based on a structure design of the elastomer structure t2, to optimize a current sharing effect.

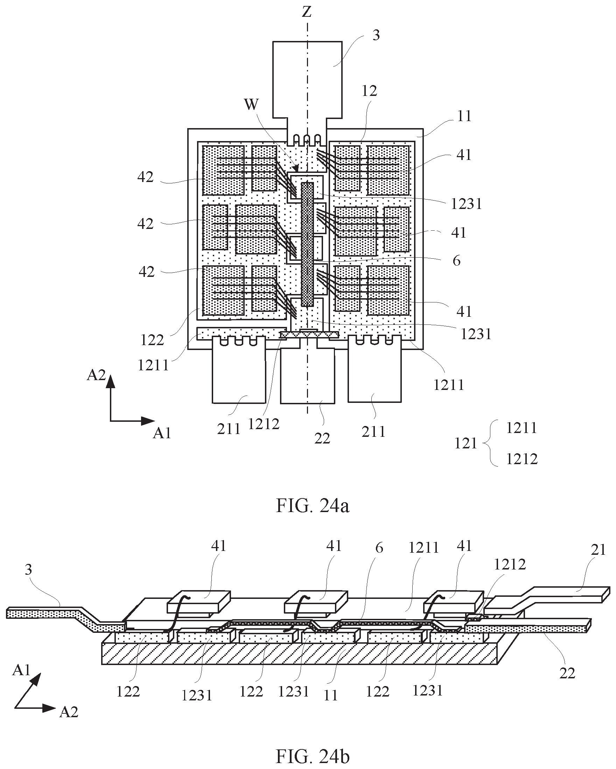

FIG. 24a shows a power module with three input terminals. As shown in FIG. 24a, a third metal layer 123 includes a plurality of isolated third metal islands 1231, and a second input terminal 22 is connected to one third metal island 1231 close to an input 2. A plurality of third metal islands 1231 are electrically connected through an adapter member 6. The adapter member 6 herein may be a copper bar or a bonding wire. A first metal layer 121 includes two isolated first metal islands 1211. The two first metal islands 1211 are arranged on two sides of a second input terminal 22 in a first direction A1. The two first metal islands 1211 are connected through a connection bridge 1212. The connection bridge 1212 crosses the second input terminal 22 in the first direction A1, so that the first metal layer 121 avoids the second input terminal 22.

The power module is sectioned along a position of a section line Z in FIG. 24a, to obtain a diagram of a cross-sectional structure shown in FIG. 24b. FIG. 24b shows a cross-sectional view of a structure on a side of a first input terminal 21 in the first direction A1. In a thickness direction of a substrate 1, the second input terminal 22 does not overlap the first metal layer 121, and the second input terminal 22 may be directly connected to the third metal island 1231 without avoiding a conductive layer 12 other than the third metal layer 123.

In the foregoing embodiment, a first switch component group G1 and a second switch component group G2 are arranged opposite to each other in the first direction A1, and the three input terminals achieve a three-input power module architecture. Compared with a two-output power module, the three-input power module architecture does not increase a size of the power module, and may further reduce parasitic inductance in a circuit.

It should be understood that, in a power module with a 3DC architecture design, the second metal layer 122 and the third metal layer 123 may alternatively be stacked in a manner in FIG. 17 or FIG. 20. Details are not described herein again.

In conclusion, according to the power module provided in this embodiment of this application, the first switch component group G1 configured to form an upper bridge arm and the second switch component group G2 configured to form a lower bridge arm are spaced apart in the first direction A1. A loop that is in a bridge arm circuit formed by the power module and that is configured to connect to a power supply has a current path in a reverse direction, so that parasitic inductance in the current loop can be reduced, and impact of the parasitic inductance on a function of the power module can be reduced. In addition, the third metal layer 123 configured to connect to the second input terminal 22 is arranged in the first switch component group G1 and the second switch component group G2 that is configured to form the lower bridge arm, so that circuit wiring of a plurality of first switch components 41 and a plurality of second switch components 42 can use a gap between the first switch component group G1 and the second switch component group G2 that is configured to form the lower bridge arm, to help reduce a size of the power module in the first direction A1. For a structure design of the entire power module, parasitic inductance in a circuit can be reduced while achieving miniaturization of a component. This helps optimize the function of the power module.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a substrate, an input, an output, a first switch component group, and a second switch component group, the substrate comprises a plurality of metal layers that are isolated from each other, and the plurality of metal layers comprise a first metal layer, a second metal layer, and a third metal layer;
the first switch component group and the second switch component group are arranged in a first direction, and the third metal layer is arranged between the first switch component group and the second switch component group in the first direction;
the first switch component group comprises a plurality of first switch components disposed on the first metal layer, and each first switch component is connected to the second metal layer;
the second switch component group comprises a plurality of second switch components disposed on the second metal layer, and each second switch component is connected to the third metal layer;
the input and the output are disposed on two sides of the substrate in a second direction, and a thickness direction of the substrate, the first direction, and the second direction are perpendicular to each other; and
the input comprises a first input terminal and a second input terminal that are spaced apart in the first direction, the first input terminal is disposed on the first metal layer, the second input terminal is disposed on the third metal layer, and the output is disposed on the second metal layer.

2. The power module according to claim 1, wherein at least a part of the second switch components are arranged in the second direction, and an end portion that is of the second input terminal and that faces the output extends in the second direction to be between the first switch component group and the second switch component group to connect to the third metal layer; and
an orthographic projection of the second input terminal on the substrate at least partially overlaps the third metal layer in the thickness direction of the substrate.

3. The power module according to claim 2, wherein the second input terminal comprises a body and at least one elastomer configured to connect to the third metal layer; and
one end or two ends of each elastomer are connected to the body, and each elastomer protrudes, in the thickness direction of the substrate, from a surface that is of the body and that faces the third metal layer.

4. The power module according to claim 3, wherein the second input terminal comprises at least one pair of parallel strip grooves, each pair of strip grooves are arranged in the first direction, and a part that is of the second input terminal and that is located between each pair of strip grooves forms one elastomer.

5. The power module according to claim 3 or 4, wherein the second input terminal comprises at least one U-shaped groove, an opening of the U-shaped groove in the second direction faces the output or the input, and a part that is of the second input terminal and that is located in the U-shaped groove forms one elastomer.

6. The power module according to any one of claims 1 to 5, wherein the second metal layer and the third metal layer are disposed on a same layer, the second metal layer comprises a notch, the third metal layer is accommodated in the notch, and there is a gap between the second metal layer and the third metal layer.

7. The power module according to claim 6, wherein the notch comprises at least one hollow structure that penetrates the second metal layer, and a position at which each first switch component is connected to the second metal layer is located between the third metal layer and the first metal layer in the first direction.

8. The power module according to claim 6, wherein the notch comprises at least one groove that is of the second metal layer and that faces an edge of the first metal layer; and
a position at which one first switch component is connected to the second metal layer and a position at which one second switch component is connected to the third metal layer are spaced apart in the second direction.

9. The power module according to any one of claims 1 to 5, wherein in a direction perpendicular to the substrate, the third metal layer and the second metal layer are stacked, and an orthographic projection of the second metal layer on the substrate overlaps an orthographic projection of the third metal layer on the substrate.

10. The power module according to any one of claims 1 to 9, wherein the third metal layer comprises a plurality of third metal islands, and each third metal island is connected to the second input terminal; and
the plurality of third metal islands are spaced apart in the second direction, and each second switch component is connected to one third metal island.

11. The power module according to any one of claims 1 to 10, wherein the first input comprises two terminal ends, and the second input terminal is arranged between the two terminal ends in the first direction; and
in the thickness direction of the substrate, an orthographic projection of the second input terminal on the third metal layer overlaps the first metal layer, and the second input terminal avoids the first metal layer.

12. The power module according to claim 11, wherein the first metal layer and the third metal layer are disposed on a same layer; and
in the thickness direction of the substrate, there is a gap between the second input terminal and the first metal layer, and a surface that is of the second input terminal and that faces the third metal layer is connected to the third metal layer through a pad.

13. The power module according to claim 11, wherein the first metal layer comprises two isolated first metal islands, and the two first metal islands are arranged on two sides of the second input terminal in the first direction; and
the two first metal islands are connected through a connection bridge, and the connection bridge crosses the second input terminal in the first direction.

14. A powertrain, wherein the powertrain comprises a controller and a motor, and the controller comprises a plurality of power modules according to any one of claims 1 to 13; and
the first input terminal and the second input terminal of each power module are respectively configured to connect to a positive electrode and a negative electrode of a power supply, and an output terminal of each power module is configured to connect to a one-phase circuit of the motor.

15. An electric vehicle, wherein the electric vehicle comprises a power supply, a wheel, and the powertrain according to claim 14, a power conversion apparatus of the powertrain is configured to: receive a direct current from the power supply, convert the direct current into an alternating current, and output the alternating current to the motor, and the motor is in transmission connection to the wheel.
